(19) Europäisches Patentamt
European Patent Office
Office européen des brevets

(11) **EP 2 713 434 A1**

(12) **DEMANDE DE BREVET EUROPEEN**

(43) Date de publication:
**02.04.2014 Bulletin 2014/14**

(51) Int Cl.:
*H01P 5/12* (2006.01)       *H01P 1/208* (2006.01)
*H01P 1/213* (2006.01)

(21) Numéro de dépôt: **13186807.7**

(22) Date de dépôt: **01.10.2013**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **01.10.2012 FR 1259276**

(71) Demandeurs:
• **CENTRE NATIONAL D'ETUDES SPATIALES**
**75001 Paris (FR)**
• **Centre National de la Recherche Scientifique (C.N.R.S)**
**75016 Paris (FR)**
• **Inria Institut National de Recherche en Informatique et en Automatique**
**78150 Le Chesnay (FR)**

• **Thales**
**92200 Neuilly Sur Seine (FR)**

(72) Inventeurs:
• **Bila, Stéphane**
**87060 LIMOGES CEDEX (FR)**
• **Estagerie, Laëtitia**
**31401 TOULOUSE CEDEX 9 (FR)**
• **Pacaud, Damien**
**31100 TOULOUSE CEDEX 1 (FR)**
• **Puech, Jérôme**
**31401 TOULOUSE CEDEX 9 (FR)**
• **Seyfert, Fabien**
**06902 SOPHIA-ANTIPOLIS CEDEX (FR)**

(74) Mandataire: **Domenego, Bertrand**
**Cabinet Lavoix**
**2, place d'Estienne d'Orves**
**75441 Paris Cedex 09 (FR)**

(54) **Dispositif routeur multiports compact**

(57)     L'invention concerne un dispositif routeur multiports adapté à acheminer un nombre P supérieur ou égal à trois de canaux fréquentiels, depuis un nombre M de ports d'entrée vers un nombre N de ports de sortie, au moins un des deux nombres M ou N étant supérieur ou égal à deux, caractérisé en ce qu'il comporte au moins deux filtres (12, 14, 16, 18), chaque filtre comportant au moins deux résonateurs couplés, au moins un résonateur (Rs1, Rs2) étant commun à deux filtres différents, chaque port d'entrée et chaque port de sortie étant connecté directement à au moins un résonateur. Le dispositif routeur est apte à réaliser un routage dans lequel sur au moins un port de sortie est fourni un multiplexe de sortie comportant au moins un premier et un deuxième canal fréquentiel, parmi lesquels le premier canal fréquentiel est issu d'un premier multiplexe d'entrée fourni sur un premier port d'entrée et comportant ledit premier canal fréquentiel et au moins un autre canal fréquentiel acheminé vers un deuxième port de sortie du dispositif, et le deuxième canal fréquentiel est soit acheminé depuis un deuxième port d'entrée, soit, lorsque ledit premier multiplexe d'entrée comporte au moins trois canaux fréquentiels différents multiplexés, ledit deuxième canal fréquentiel est issu dudit premier multiplexe d'entrée, lesdits premier et deuxième canal fréquentiel étant disposés fréquentiellement de part et d'autre d'un troisième canal fréquentiel, ledit troisième canal fréquentiel étant routé vers un autre port de sortie.

FIG.2

**Description**

La présente invention concerne un dispositif routeur multiports adapté à acheminer un nombre P supérieur ou égal à trois de canaux fréquentiels, depuis un nombre M de ports d'entrée vers un nombre N de ports de sortie.

L'invention se situe dans le domaine des communications hyperfréquences et micro-ondes, et trouve une application particulière dans les satellites de télécommunications.

On connaît dans l'état de la technique diverses architectures de dispositifs aptes à réaliser des fonctions de communications hyperfréquences, en particulier des fonctions de filtrage, de multiplexage et de routage de signaux hyperfréquences transportés par des canaux fréquentiels ayant chacun une porteuse hyperfréquence associée.

La fonction de filtrage de canaux fréquentiels consiste à filtrer une ou plusieurs porteuses dans un canal fréquentiel prédéterminé, permettant ainsi de séparer plusieurs canaux fréquentiels.

Une fonction de multiplexage d'entrée consiste soit à séparer un train de porteuses ou multiplexe fréquentiel composé de P canaux fréquentiels différents d'entrée, reçu sur un seul port d'entrée d'un dispositif de multiplexage, en P canaux fréquentiels de sortie, chacun acheminé sur un port différent. De manière duale, une fonction de multiplexage de sortie consiste à combiner P canaux fréquentiels reçus sur M ports d'entrée en un multiplexe de sortie composé des P canaux fréquentiels, acheminé sur un port de sortie.

Une fonction de routage consiste à séparer un nombre P de canaux fréquentiels reçus sur M ports d'entrée vers un nombre N de ports de sortie, en recombinant les canaux fréquentiels des multiplexes d'entrée dans des multiplexes de sortie. Plus précisément, une fonction de routage d'entrée, qu'on appellera à sortie partagée, consiste à séparer au moins un premier canal d'un premier multiplexe d'entrée fourni sur un premier port d'entrée et à l'acheminer vers un premier multiplexe de sortie d'un premier port de sortie, le premier multiplexe de sortie comportant également un deuxième canal issu d'un deuxième multiplexe d'entrée fourni sur un deuxième port d'entrée. On définit de façon duale le routage de sortie à entrée partagée.

Comme on peut le constater, les fonctions de routage, respectivement routage d'entrée à sortie partagée ou routage de sortie à entrée partagée, diffèrent du multiplexage car impliquent une séparation et une recombinaison des canaux fréquentiels entre entrée et sortie. La réalisation des fonctions de routage est par conséquent bien plus complexe que la réalisation des fonctions de multiplexage.

Il est connu de réaliser un dispositif routeur en combinant des diplexeurs ou en associant des filtres de résonateurs, les connexions étant réalisées à l'aide d'éléments de division et de combinaison passifs, comme par exemple des guides d'ondes, des jonctions en « T », des diviseurs, des circulateurs et des isolateurs. Un tel dispositif routeur présente un encombrement et une masse importants, ainsi que des pertes d'insertion supplémentaires.

Il est souhaitable de réaliser des dispositifs routeurs multiports aptes à réaliser à la fois des fonctions de filtrage et de routage d'entrée à sortie partagée et/ou de routage de sortie à entrée partagée, qui soient plus compacts et plus performants que les dispositifs connus.

A cet effet, l'invention propose un dispositif routeur multiports adapté à acheminer un nombre P supérieur ou égal à trois de canaux fréquentiels, depuis un nombre M de ports d'entrée vers un nombre N de ports de sortie, au moins un des deux nombres M ou N étant supérieur ou égal à deux. Le routeur est **caractérisé en ce qu'il** comporte au moins deux filtres, chaque filtre comportant au moins deux résonateurs couplés, au moins un résonateur étant commun à deux filtres différents, chaque port d'entrée et chaque port de sortie étant connecté directement à au moins un résonateur. Le dispositif routeur est apte à réaliser un routage dans lequel sur au moins un port de sortie est fourni un multiplexe de sortie comportant au moins un premier et un deuxième canal fréquentiel, parmi lesquels :

- le premier canal fréquentiel est issu d'un premier multiplexe d'entrée fourni sur un premier port d'entrée et comportant ledit premier canal fréquentiel et au moins un autre canal fréquentiel acheminé vers un deuxième port de sortie du dispositif, et
- le deuxième canal fréquentiel est soit acheminé depuis un deuxième port d'entrée, soit, lorsque ledit premier multiplexe d'entrée comporte au moins trois canaux fréquentiels différents multiplexés, ledit deuxième canal fréquentiel est issu dudit premier multiplexe d'entrée, lesdits premier et deuxième canal fréquentiel étant disposés fréquentiellement de part et d'autre d'un troisième canal fréquentiel, ledit troisième canal fréquentiel étant routé vers un autre port de sortie.

Avantageusement, le dispositif routeur multiports selon l'invention est compact dans la mesure où chaque port d'entrée et chaque port de sortie est connecté directement à au moins un résonateur, sans éléments de connexion comme des guides d'ondes ou des jonctions. Ainsi, l'invention permet d'obtenir un gain en encombrement et en masse par rapport aux solutions existantes, et également d'améliorer les performances électriques en limitant les pertes d'insertion et en éliminant les pics parasites de recombinaison qui sont classiquement dûs à l'utilisation d'éléments de connexion comme les guides d'ondes.

Selon une caractéristique, le dispositif routeur est apte à fonctionner de manière réversible, lesdits ports de sortie étant utilisés comme ports d'entrée et lesdits ports d'entrée étant utilisés comme ports de sortie.

Avantageusement, la fonction de filtrage et la fonction de routage d'entrée à sortie partagée et/ou de routage de sortie à entrée partagée sont réalisées en un seul dispositif routeur multiports compact.

Le dispositif routeur multiports selon l'invention peut présenter une ou plusieurs des caractéristiques ci-dessous, prises indépendamment ou en combinaison :

- ledit routage est réalisé par des couplages entre résonateurs de filtres différents, lesdits couplages étant sélectionnés pour réaliser un routage selon un plan de routage prédéterminé des P canaux fréquentiels obtenus sur M ports d'entrée vers N ports de sortie ;
- il comporte au moins deux ports d'entrée et au moins deux ports de sortie ;
- au moins deux canaux fréquentiels issus de deux ports d'entrée différents sont identiques ;
- chaque port d'entrée est couplé à deux résonateurs via une cavité résonante bi-mode ;
- il comporte un nombre de filtres égal au nombre P de canaux fréquentiels ;
- chaque filtre est composé d'un groupe de même nombre de résonateurs couplés en cascade ;
- au moins un filtre comporte au moins un noeud non résonant.

D'autres caractéristiques et avantages de l'invention ressortiront de la description qui en est donnée ci-dessous, à titre indicatif et nullement limitatif, en référence aux figures annexées, parmi lesquelles :

- la figure 1 est une illustration fonctionnelle schématique d'un dispositif routeur à deux ports d'entrée et deux ports de sortie, quatre canaux ;
- la figure 2 illustre schématiquement un mode de réalisation du dispositif routeur multiports de la figure 1 ;
- la figure 3 illustre une variante du mode de réalisation de la figure 2 ;
- la figure 4 illustre un mode de réalisation du dispositif routeur multiports compact de la figure 2 comportant des cavités bi-mode ;
- la figure 5 est un graphe illustrant les réponses en transmission pour un exemple du mode de réalisation de la figure 4 ;
- les figures 6 et 7 sont des graphes des réponses en réflexion pour un exemple du mode de réalisation de la figure 4 ;
- la figure 8 illustre fonctionnellement un dispositif routeur multiports à une entrée, deux sorties, quatre canaux;
- la figure 9 illustre schématiquement un mode de réalisation du dispositif routeur multiports de la figure 8 ;
- la figure 10 illustre fonctionnellement un dispositif routeur multiports à deux entrées, trois sorties, six canaux;
- la figure 11 illustre schématiquement un mode de réalisation du dispositif routeur multiports de la figure 10 ;

- la figure 12 illustre fonctionnellement un dispositif routeur multiports à trois entrées, trois sorties, cinq canaux, et
- la figure 13 illustre schématiquement un mode de réalisation du dispositif routeur multiports de la figure 12.

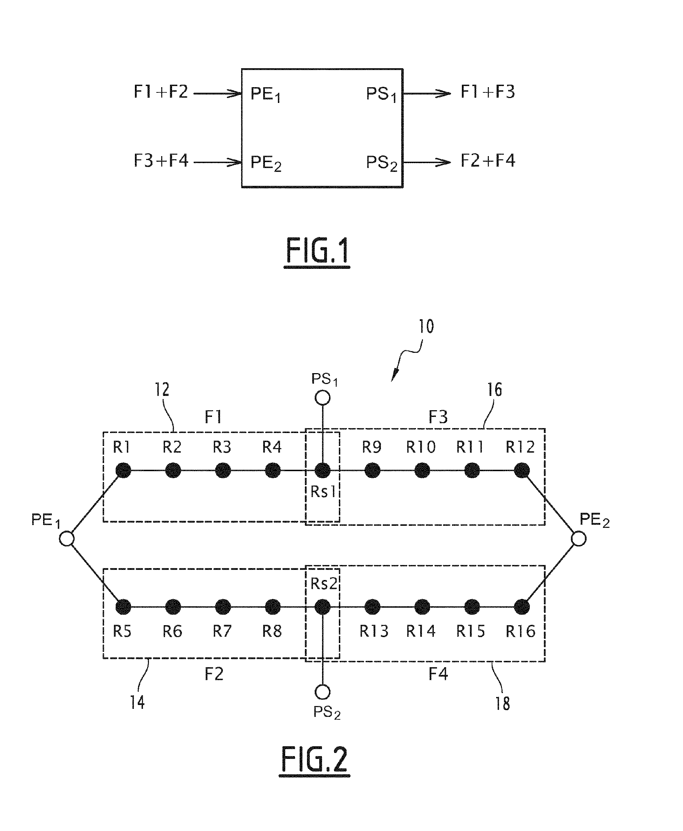

La figure 1 illustre de manière fonctionnelle un dispositif routeur multiports comportant deux ports d'entrée notés respectivement $PE_1$ et $PE_2$ et deux ports de sortie notés respectivement $PS_1$ et $PS_2$, apte à séparer quatre canaux fréquentiels, chaque canal fréquentiel ayant une porteuse associée notées respectivement F1, F2, F3 et F4.

Pour simplifier l'expression on désignera par la suite chaque canal fréquentiel par la ou les porteuses associées.

Un premier multiplexe d'entrée, acheminé sur le port d'entrée $PE_1$, comprend deux canaux de fréquences porteuses F1 et F2, et un deuxième multiplexe d'entrée, acheminé sur le port d'entrée $PE_2$, comprend deux canaux de fréquences porteuses F3 et F4. Les canaux sont respectivement séparés et recombinés. Ainsi, le canal de fréquence F1 du premier multiplexe d'entrée est fourni sur le premier multiplexe de sortie sur le port de sortie $PS_1$. Le premier multiplexe de sortie comporte également le canal de fréquence F3 issu du deuxième multiplexe d'entrée fourni sur le deuxième port d'entrée. Le deuxième multiplexe de sortie fourni sur le port de sortie $PS_2$ recombine le canal de fréquence F2 issu du premier multiplexe d'entrée fourni sur le premier port d'entrée $PE_1$ et le canal de fréquence F4 issu du deuxième multiplexe d'entrée fourni sur le deuxième port d'entrée $PE_2$. Par exemple, dans une des applications de l'invention qui est une application de télécommunications, les canaux fréquentiels ont une bande passante de 33MHz, les fréquences porteuses étant comprises dans la bande de fréquence Ku, de 10,7GHz à 12,75GHz.

Un dispositif routeur multiports 10 selon l'invention à deux entrées, deux sorties et quatre canaux, appelé également routeur 2x2 à 4 canaux, est schématiquement illustré à la figure 2. Le dispositif routeur 10 de cet exemple comprend deux ports d'entrée notés respectivement $PE_1$ et $PE_2$, et deux ports de sortie $PS_1$ et $PS_2$, comme dans l'exemple générique précédent de la figure 1. Chaque multiplexe d'entrée comprend deux canaux fréquentiels.

Les canaux fréquentiels sont séparés par des filtres 12, 14, 16, 18, chaque filtre étant formé par un groupe de résonateurs couplés en cascade comme illustré à la figure 2.

De manière plus générale, un filtre comprend des résonateurs interconnectés entre eux, et peut également comprendre, en variante, des noeuds non résonants (« non resonating nodes » en anglais) entre deux résonateurs.

Le port d'entrée $PE_1$ est couplé directement aux résonateurs R1 et R5, le port d'entrée PE$_2$ est couplé directement aux résonateurs R12 et R16. Le port de sortie PS$_1$ est couplé au résonateur commun Rs1, et le port de sortie PS$_2$ est couplé au résonateur commun Rs2.

Le filtre 12 est un filtre passe-bande réglé sur la fréquence porteuse F1 correspondant au premier canal d'entrée du premier multiplexe d'entrée. Ce filtre comprend des résonateurs notés R1, R2, R3, R4 et Rs1, couplés en série.

Le filtre 14 est un filtre passe-bande réglé sur la fréquence porteuse F2 correspondant au deuxième canal d'entrée du premier multiplexe d'entrée. Ce filtre comprend des résonateurs notés R5, R6, R7, R8 et Rs2, couplés en série.

Le filtre 16 est un filtre passe-bande réglé sur la fréquence porteuse F3 correspondant au premier canal d'entrée du deuxième multiplexe d'entrée. Ce filtre comprend des résonateurs notés R12, R11, R10, R9 et Rs1, couplés en série.

Le filtre 18 est un filtre passe-bande réglé sur la fréquence porteuse F4 correspondant au deuxième canal d'entrée du deuxième multiplexe d'entrée. Ce filtre comprend des résonateurs notés R16, R15, R14, R13 et Rs2, couplés en série.

Comme on peut le constater, dans l'exemple de topologie illustré à la figure 2, le résonateur Rs1 est couplé électromagnétiquement avec le résonateur R4 et participe au filtre 12, mais aussi, de la même façon, Rs1 est couplé électromagnétiquement avec le résonateur R9 et participe au filtre 16. De manière analogue, le résonateur Rs2 est couplé électromagnétiquement avec le résonateur R8 et participe au filtre 14, mais aussi, de la même façon, Rs2 est couplé électromagnétiquement avec le résonateur R13 et participe au filtre 18. Chacun des résonateurs respectifs Rs1 et Rs2 est commun à deux filtres différents.

Selon une variante, d'autres couplages entre les résonateurs formant un filtre sont possibles, selon des variantes de topologie de couplage connues. Par exemple, dans le filtre 12, les résonateurs R1 et R4 peuvent être également couplés, afin d'améliorer les performances électriques du système, par la création de zéros de transmission par exemple.

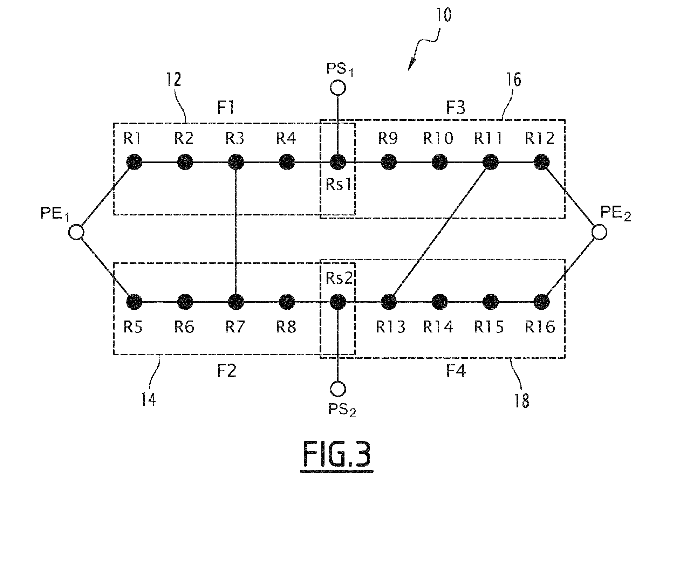

La figure 3 illustre une variante du routeur à deux entrées, deux sorties et quatre canaux de la figure 2. Dans cette variante, les résonateurs R3 et R7 des filtres F1 et F2 sont en outre couplés entre eux. De plus, les résonateurs R11 et R13 des filtres respectifs F3 et F4 sont également couplés entre eux.

Bien entendu, d'autres topologies de connexion (non illustrées) sont envisageables. Par exemple, l'ensemble des résonateurs pourraient être commun aux filtres, avec des connections verticales ou diagonales entre résonateurs.

Les couplages entre résonateurs sont sélectionnés pour réaliser un routage selon un plan de routage prédéterminé des P canaux fréquentiels obtenus sur M ports d'entrée vers N ports de sortie.

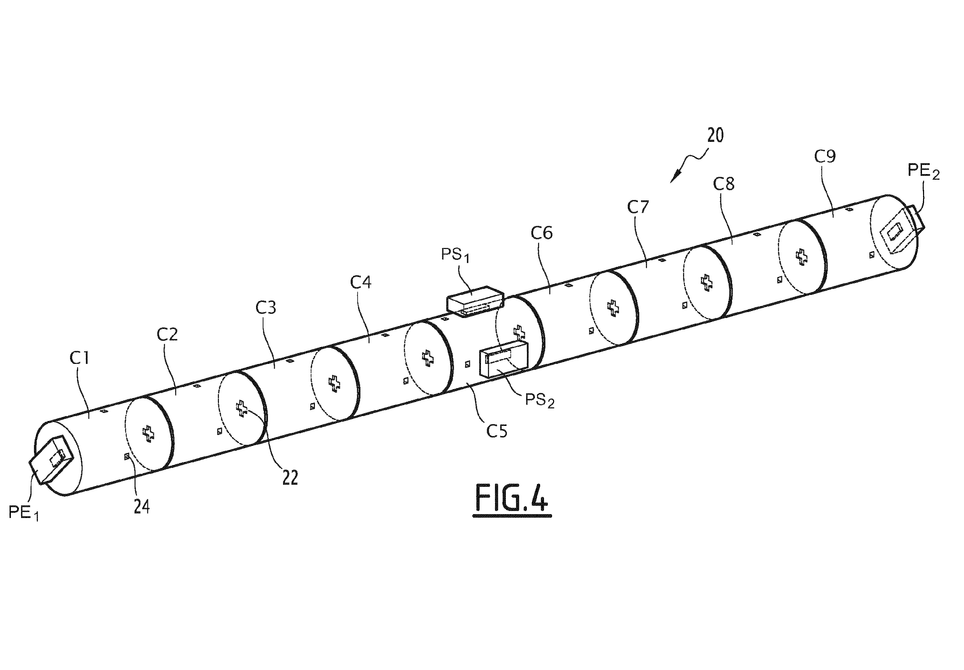

Selon le mode de réalisation illustré à la figure 4, le dispositif routeur multiports est réalisé par un dispositif 20 à cavités bi-modes. Le dispositif 20 comprend neuf cavités bi-modes, notées respectivement C1 à C9. Chaque cavité comprend une paire de résonateurs, selon des modes de résonance différents, polarisés à 90° l'un de l'autre, respectivement la cavité C1 comprend les résonateurs R1 et R5, la cavité C2 comprend les résonateurs R2 et R6, et ainsi de suite.

Les cavités adjacentes sont couplées par des iris 22 dans ce mode de réalisation. De plus, des vis 24 de couplage et de réglage sont également utilisées pour régler les fréquences de résonance et coupler les polarisations entre elles.

La cavité notée C5 comprend les deux résonateurs Rs1 et Rs2 auxquels sont respectivement couplés les ports de sortie PS$_1$ et PS$_2$. Comme illustré à la figure 4, les ports de sortie PS$_1$ et PS$_2$ sont disposés à la périphérie de la cavité C5 en des emplacements angulairement différents.

Les filtres 12 et 14 sont réalisés en tant que filtre bi-bande par les cavités C1 à C5 et les filtres 16 et 18 sont réalisés en tant que filtre bi-bande par les cavités C5 à C9.

Selon un mode de réalisation, qui est appelé mode de réalisation co-fréquence, les fréquences porteuses F1 et F4 et/ou les fréquences porteuses F2 et F3 sont identiques (principe de la réutilisation de fréquences pour applications de télécommunications spatiales). Avantageusement, il est possible de réaliser la fonction de routage pour des applications exploitant les mêmes canaux fréquentiels pour transmettre des informations différentes.

Un dispositif routeur multiports tel que décrit en référence à la figure 2 est caractérisé par une matrice de couplage normalisée obtenue dans une phase préalable de synthèse permettant de définir l'architecture optimale réalisant le plan de routage choisi. Une matrice de couplage est une matrice, qui représente le couplage électromagnétique pour chaque paire d'éléments du dispositif routeur (noté M$_{ij}$), la fréquence de résonance pour chaque résonateur participant à la fonction de filtrage (représentée par le terme M$_{ii}$) et le couplage électromagnétique en entrée et en sortie sur chacun des ports avec le ou les résonateurs mis en jeu (noté R$_{in}$ et R$_{out}$, respectivement résistances d'entrée et de sortie).Dans un exemple de réalisation illustré en détail ci-après, la matrice de couplage est une matrice carrée symétrique et toutes les valeurs de couplage sont égales à 0 à l'exception des valeurs de couplage suivantes, où C(Ei, Ej) représente la valeur de couplage entre les éléments Ei et Ej :

C(PE$_1$, R1)=1,010 ; C(PE$_1$, R5)=1,010 ;
C(PE$_2$, R12)=1,010 ; C(PE$_2$, R16)=1,010 ;

C(R1, R1)= -3,838 ; C(R1,R2)=0,759 ;
C(R2,R2)= -3,460 ; C(R2,R3)=0,636 ;

C(R3,R3)= -3,215 ; C(R3, R4)=1,017 ;
C(R4,R4)= -1,678 ; C(R4,Rs1)=2,360 ;

C(R5,R5)=-0,753 ; C(R5,R6)=0,747 ;
C(R6,R6)= -1,121 ; C(R6,R7)=0,581 ;
C(R7,R7)= -1,182 ; C(R7,R8)=0,594 ;
C(R8,R8)= -1,167 ; C(R8,Rs2)=1,137

C(Rs1, Rs1)= -1,140 ; C(Rs1,R9)=1,133 ; C(Rs1, $PS_1$)=1, 383 ;

C(Rs2, Rs2)=1,079 ; C(Rs2, R13)=2,349 ; C(Rs2, $PE_2$)=1,383 ;

C(R9,R9)=1,162 ; C(R9,R10)=0,592 ;
C(R10,R10)=1,178 ; C(R10,R11)=0,580 ;
C(R11,R11)=1,117 ; C(R11,R12)=0,745 ;
C(R12, R12)=0,750 ;

C(R13,R13)=1,667 ;C(R13,R14)=0,999 ;
C(R14,R14)=3,216 ; C(R14,R15)=0,629 ;
C(R15, R15)=3,446 ; C(R15,R16)=0,751 ;
C(R16,R16)=3,834 ;

Les valeurs données sont normalisées par rapport à une fréquence $f_0$ telle que

$$f_i = f_0 \sqrt{\frac{\frac{f_0}{\Delta f} + \frac{M_{ii}}{2}}{\frac{f_0}{\Delta f} - \frac{M_{ii}}{2}}}$$

Avec $f_0$ la fréquence centrale du canal,
$f_i$ la fréquence de résonance du résonateur i considéré,
$M_{ii}$ le paramètre normalisé de la matrice de couplage relatif à la fréquence de résonance du résonateur i,
Et $\Delta f$ la bande passante équiondulation du canal considéré.
Les résistances d'entrée/sortie $R_{in}$ et $R_{out}$ dépendent des systèmes d'excitation et sont donc directement liées à un paramètre appelé facteur de qualité extérieur $Q_{ext}$ par la relation :

$$R = \frac{f_0}{\Delta f_{-3dB} \times Q_{ext}}$$

Les termes $M_{ij}$, eux aussi normalisés et expriment les différents couplages entre les éléments résonants et sont liés aux coefficients de couplage $k_{ij}$ par la formule suivante :

$$k_{ij} = \frac{\Delta f_{\text{équiond.}}}{f_0} \times M_{ij}$$

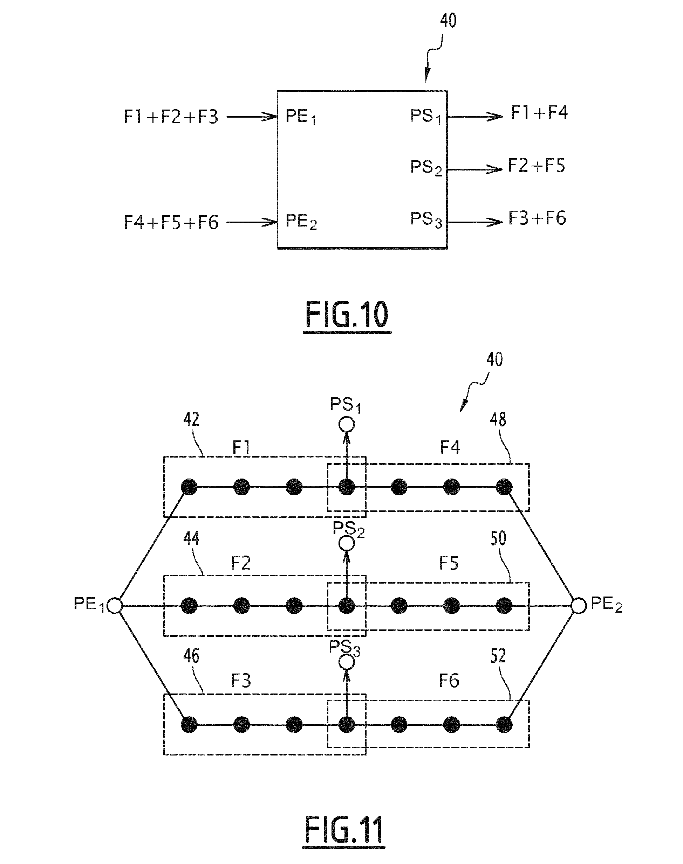

Ces coefficients représentent l'intensité de l'interaction qui existe entre deux résonances.
Les fréquences porteuses respectives sont les suivantes dans cet exemple : F1 = 11.843 GHz, F2 = 11.881 GHz, F3 = 11.919 GHz et F4 = 11.957 GHz.

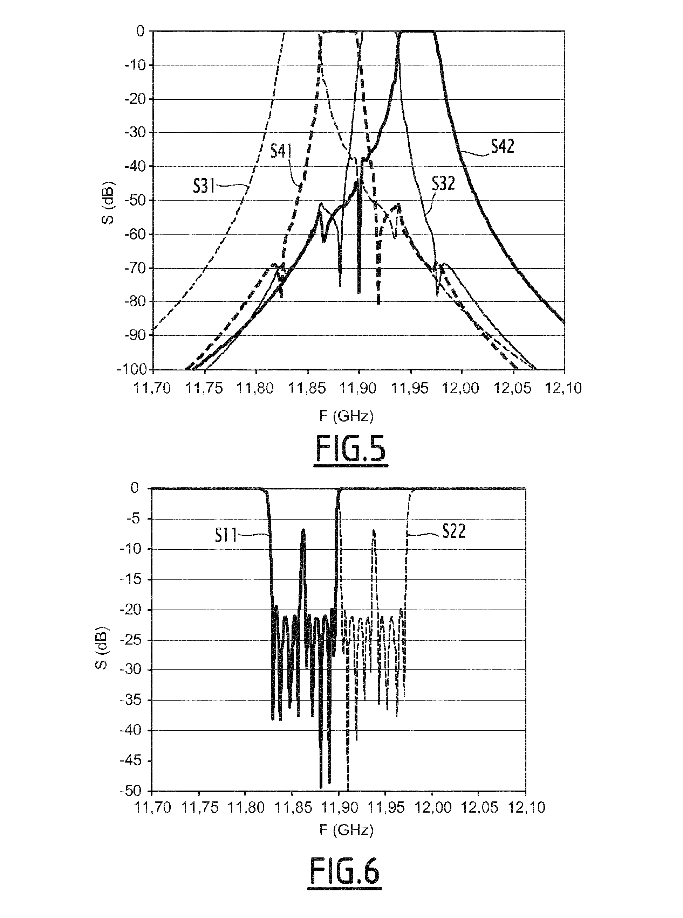

La figure 5 illustre, dans ce mode de réalisation et pour la matrice de couplage dont les valeurs sont détaillées ci-dessus en exemple, les pertes en transmission entre les divers ports, exprimées en Décibels (dB) en fonction de la fréquence exprimée en GHz.

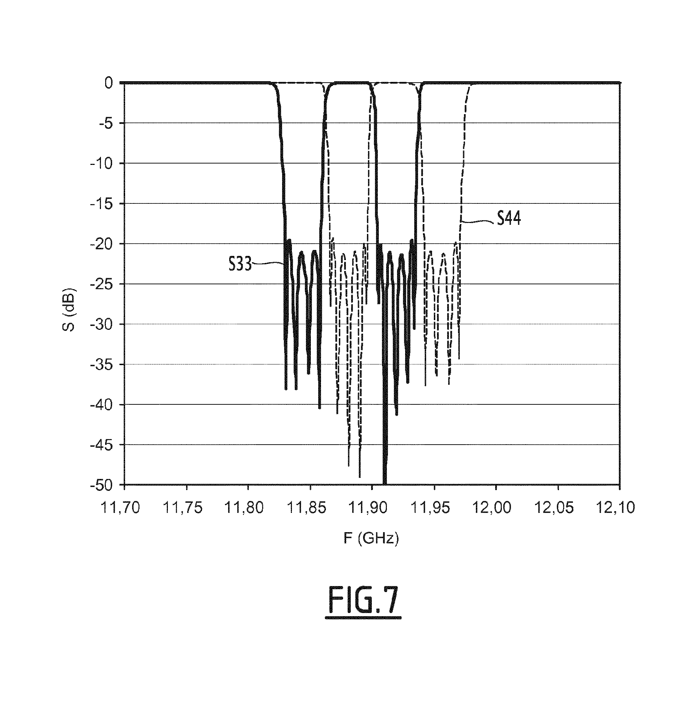

Les figures 6 et 7 illustrent les réponses en réflexion pour chacun des ports.

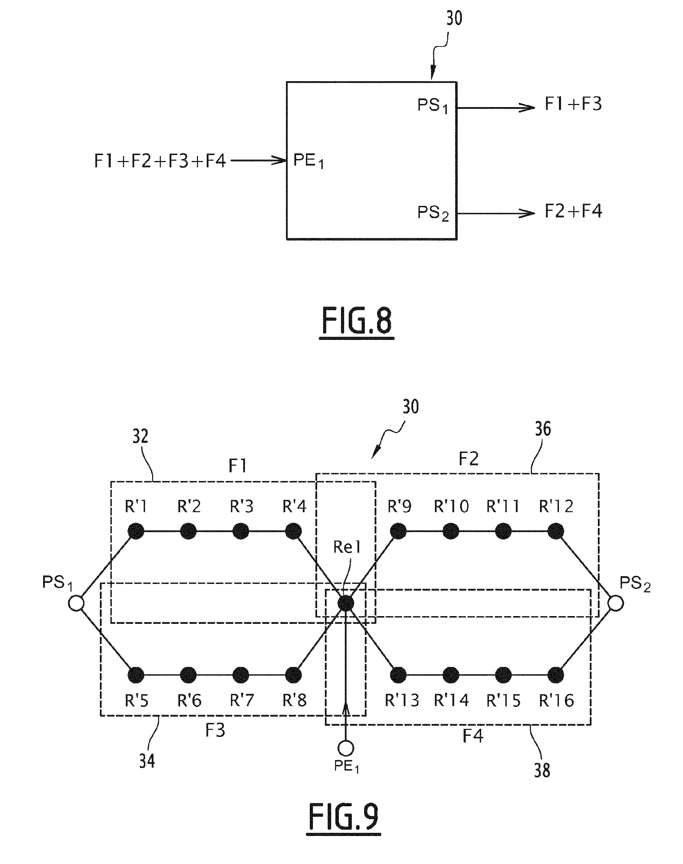

La figure 8 illustre fonctionnellement un dispositif routeur multiports 30 qui comporte un seul port d'entrée et deux ports de sortie, donc M=1 et N=2, et le nombre de canaux à séparer et à recombiner est P=4 (routeur 1x2, 4 canaux). De manière plus générale, il y a un routage de sortie à entrée partagée dès que le nombre de canaux d'entrée de fréquence porteuses différentes à séparer et à recombiner est supérieur ou égal à 3, dans le cas où le dispositif routeur comporte un port d'entrée et deux ports de sortie.
Dans ce cas particulier illustré fonctionnellement à la figure 8, un multiplexe d'entrée acheminant les canaux F1+F2+F3+F4, les fréquences porteuses respectives F1, F2, F3 et F4 étant différentes, est acheminé vers deux ports de sortie $PS_1$ et $PS_2$, avec une recombinaison des canaux fréquentiels non adjacents : le premier multiplexe de sortie, acheminé sur le port $PS_1$, est composé des canaux fréquentiels F1+F3, et le deuxième multiplexe de sortie, acheminé sur le port $PS_2$, est composé des canaux fréquentiels F2+F4. Il est à souligner qu'il s'agit bien de la réalisation d'une fonction de routage de sortie à entrée partagée dans cet exemple, et non d'un simple multiplexage dans la mesure où les canaux fréquentiels de sortie sont séparés et recombinés, la recombinaison consistant à recombiner dans un multiplexe de sortie au moins deux canaux (par exemple F1 et F3) qui sont situés fréquentiellement de part et d'autre d'un canal (par exemple F2) qui est acheminé sur un autre port de sortie (le port $PS_2$ dans cet exemple).
Selon un mode de réalisation illustré à la figure 9, le dispositif routeur à un port d'entrée et deux ports de sortie est réalisé à l'aide de quatre filtres 32, 34, 36 et 38, chacun composé de quatre résonateurs couplés. Le port d'entrée $PE_1$ est directement connecté à un résonateur Re1, qui est par exemple de type cavité, comme dans l'exemple de mise en oeuvre de la figure 4. Le résonateur Re1 est couplé aux résonateurs respectifs R'4, R'8, R'9 et R'13, faisant partie des filtres des canaux de fréquences porteuses respectives F1, F2, F3 et F4.
Un troisième exemple de dispositif routeur multiports selon l'invention est illustré aux figures 10 et 11.

Dans cet exemple, le dispositif routeur 40 est un routeur 2x3, 6 canaux comportant deux ports d'entrée (M=2) notés respectivement $PE_1$ et $PE_2$ et trois ports de sortie (N=3), notés $PS_1$, $PS_2$ et $PS_3$. Un nombre P=6 de canaux fréquentiels est acheminé : chaque multiplexe d'entrée est un multiplexe à trois canaux fréquentiels, et chaque multiplexe de sortie est un multiplexe à deux canaux fréquentiels. Les canaux fréquentiels sont séparés et recombinés selon le plan de routage illustré à la figure 10. Comme illustré à la figure 11, selon un mode de réalisation pour la fonction de routage illustrée à la figure 10, chaque port d'entrée respectif est directement couplé à trois résonateurs, et chaque port de sortie est couplé directement à un seul résonateur. Ainsi, selon un mode de réalisation de l'invention, généralisable à un nombre quelconque de ports d'entrée et de sortie, chaque port peut être couplé à autant de résonateurs que le nombre de canaux fréquentiels acheminés sur ce port.

Dans l'exemple de la figure 11, chaque filtre respectif 42, 44, 46, 48, 50 et 52, est réalisé par un groupe de quatre résonateurs couplés en série. Néanmoins, le nombre de résonateurs en série peut, en variante, être variable d'un filtre à l'autre.

Un dispositif résonateur multiports 40 est par exemple réalisable avec une technologie de cavités trimodes couplées.

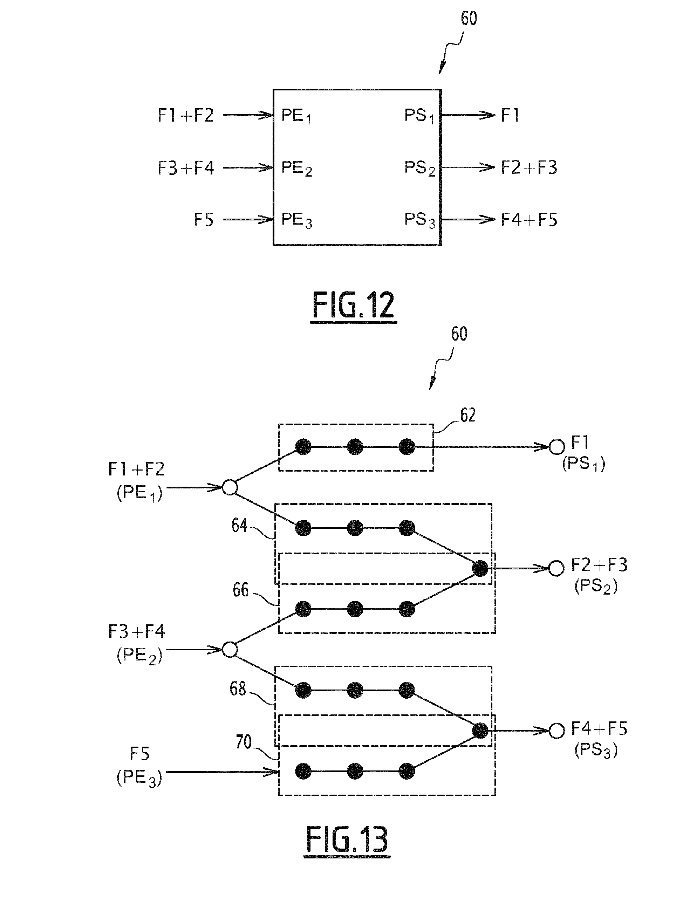

Une quatrième fonction de routage d'un dispositif routeur multiports compact selon l'invention est illustrée aux figures 12 et 13. Le dispositif routeur 60 est un routeur 3x3, 5 canaux, qui comporte donc M=3 ports d'entrée, N=3 ports de sortie, et est apte à acheminer P=5 canaux fréquentiels. Selon le plan de routage illustré à la figure 12, un premier multiplexe temporel à deux canaux est acheminé sur le port d'entrée $PE_1$, un deuxième multiplexe temporel à deux canaux est acheminé sur le port d'entrée $PE_2$ et un seul canal fréquentiel est acheminé sur le port d'entrée $PE_3$. Les ports de sortie sont notés $PS_1$, $PS_2$ et $PS_3$, et seul le canal fréquentiel de fréquence porteuse F1 est acheminé sur $PS_1$, alors que les autres canaux fréquentiels sont recombinés sur des multiplexes à deux canaux fréquentiels sur les ports respectifs $PS_2$ et $PS_3$.

Un mode de réalisation de la fonction de routage avec des résonateurs couplés est illustré à la figure 13. Le dispositif routeur 60 comporte cinq filtres notés respectivement 62, 64, 66, 68 et 70, formés de résonateurs couplés en série. Les filtres 64, 66 comportent chacun quatre résonateurs, le résonateur couplé au port de sortie $PS_2$ étant commun aux deux filtres. De même, les filtres 68, 70 comportent chacun quatre résonateurs, dont un résonateur commun couplé au port de sortie $PS_3$.

Les ports d'entrée $PE_1$ et $PE_2$ sont couplés chacun à deux résonateurs appartenant à deux filtres différents, respectivement les filtres 62 et 64 pour le port d'entrée $PE_1$ et les filtres 66 et 68 pour le port d'entrée $PE_2$. Le port d'entrée $PE_3$ est couplé directement à un seul résonateur du filtre 70. En sortie, les ports $PS_2$ et $PS_3$ sont chacun couplés à un résonateur commun de deux filtres différents, alors que le port de sortie $PS_1$ est couplé à un seul résonateur du filtre 62.

Il est à noter que les dispositifs routeurs multiports selon l'invention sont réversibles, et donc utilisables avec les ports de sortie en ports d'entrée et les ports d'entrée en ports de sortie.

Les exemples ci-dessus ont été décrits avec une réalisation des résonateurs composant les dispositifs routeurs multiports en cavités bi-modes ou tri-modes. En alternative, d'autres technologies connues de réalisation des résonateurs sont envisageables, ainsi que d'autres modes de couplage.

Selon des modes de réalisation alternatifs, des couplages parallèles entre résonateurs différents participant à des filtres différents peuvent être ajoutés, afin de réaliser des fonctions de routage selon un plan de routage prédéterminé.

Avantageusement, l'invention permet de réaliser des dispositifs routeurs multiports compacts, sans besoin d'éléments de jonction supplémentaires, tout en améliorant les performances électriques par rapport aux dispositifs routeurs existants, par la diminution des pertes d'insertion et l'élimination de pics parasites de recombinaison.

## Revendications

1. Dispositif routeur multiports adapté à acheminer un nombre P supérieur ou égal à trois de canaux fréquentiels, depuis un nombre M de ports d'entrée vers un nombre N de ports de sortie, au moins un des deux nombres M ou N étant supérieur ou égal à deux, **caractérisé en ce qu'il** comporte au moins deux filtres (12, 14, 16, 18, 32, 34, 36, 38, 42, 44, 46, 48, 50, 52, 62, 64, 66, 68, 70), chaque filtre comportant au moins deux résonateurs couplés, au moins un résonateur (Rs1, Rs2, Re1) étant commun à deux filtres différents, chaque port d'entrée et chaque port de sortie étant connecté directement à au moins un résonateur, le dispositif routeur étant apte à réaliser un routage dans lequel sur au moins un port de sortie est fourni un multiplexe de sortie comportant au moins un premier et un deuxième canal fréquentiel, parmi lesquels :

   - le premier canal fréquentiel est issu d'un premier multiplexe d'entrée fourni sur un premier port d'entrée et comportant ledit premier canal fréquentiel et au moins un autre canal fréquentiel acheminé vers un deuxième port de sortie du dispositif, et
   - le deuxième canal fréquentiel est
   soit acheminé depuis un deuxième port d'entrée,
   soit, lorsque ledit premier multiplexe d'entrée comporte au moins trois canaux fréquentiels différents multiplexés, ledit deuxième canal fréquentiel est issu dudit premier multiplexe d'entrée, lesdits premier et deuxième canal fréquentiel étant disposés fréquentiellement de part et d'autre d'un troisième canal fréquentiel, ledit troisième canal fréquentiel étant routé vers un autre port de sortie.

2. Dispositif routeur multiports selon la revendication 1, **caractérisé en ce qu'il** est apte à fonctionner de manière réversible, lesdits ports de sortie étant utilisés comme ports d'entrée et lesdits ports d'entrée étant utilisés comme ports de sortie.

3. Dispositif routeur multiports selon l'une quelconque des revendications précédentes **caractérisé en ce que** ledit routage est réalisé par des couplages entre résonateurs de filtres différents, lesdits couplages étant sélectionnés pour réaliser un routage selon un plan de routage prédéterminé des P canaux fréquentiels obtenus sur M ports d'entrée vers N ports de sortie.

4. Dispositif routeur multiports selon l'une quelconque des revendications précédentes, **caractérisé en ce qu'il** comporte au moins deux ports d'entrée et au moins deux ports de sortie.

5. Dispositif routeur multiports selon la revendication 4, **caractérisé en ce qu'**au moins deux canaux fréquentiels issus de deux ports d'entrée différents sont identiques.

6. Dispositif routeur multiports selon l'une des revendications 4 ou 5, **caractérisé en ce que** chaque port d'entrée est couplé à deux résonateurs via une cavité résonante bi-mode.

7. Dispositif routeur multiports selon l'une quelconque des revendications précédentes, **caractérisé en ce qu'il** comporte un nombre de filtres égal au nombre P de canaux fréquentiels.

8. Dispositif routeur multiports selon la revendication 7, **caractérisé en ce que** chaque filtre est composé d'un groupe de même nombre de résonateurs couplés en cascade.

9. Dispositif routeur multiports selon l'une des revendications 1 à 7, **caractérisé en ce qu'**au moins un filtre comporte au moins un noeud non résonant.

FIG.1

FIG.2

FIG.3

FIG.4

FIG.5

FIG.6

FIG.7

30

F1+F2+F3+F4 ⟶ PE₁    PS₁ ⟶ F1+F3

PS₂ ⟶ F2+F4

## FIG.8

## FIG.9

F1+F2+F3 → PE$_1$    PS$_1$ → F1+F4

                     PS$_2$ → F2+F5

F4+F5+F6 → PE$_2$    PS$_3$ → F3+F6

40

## FIG.10

PS$_1$

40

42    F1         F4    48

PE$_1$    F2         F5    PE$_2$

44         PS$_2$         50

46    F3         F6    52

PS$_3$

## FIG.11

14

## FIG.12

## FIG.13

Europäisches
Patentamt

European
Patent Office

Office européen
des brevets

**RAPPORT DE RECHERCHE EUROPEENNE**

Numéro de la demande

EP 13 18 6807

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EZZEDDINE H ET AL: "Coupling topologies for realizing compact microwave diplexers with dual-mode cavities", MICROWAVE SYMPOSIUM DIGEST (MTT), 2010 IEEE MTT-S INTERNATIONAL, IEEE, PISCATAWAY, NJ, USA, 23 mai 2010 (2010-05-23), pages 880-883, XP031713890, ISBN: 978-1-4244-6056-4 * page 880, colonne de droite, ligne 1 - page 881, ligne 2; figures 2,3 * * page 881, colonne de droite, ligne 1 - ligne 12; figures 6,7 * * page 882, colonne de droite, ligne 1 - page 883, colonne de droite, ligne 13 * ----- | 1-9 | INV. H01P5/12 H01P1/208 H01P1/213 |
| Y | EP 0 987 786 A2 (HUGHES ELECTRONICS CORP [US] L 3 COMM ELECTRON TECHNOLOGIES [US]) 22 mars 2000 (2000-03-22) * alinéa [0015] - alinéa [0024]; figures 1,2 * ----- | 1-9 | |
| Y | EP 0 096 461 A2 (ANDREW CORP [US]) 21 décembre 1983 (1983-12-21) * page 6, ligne 5 - page 8, ligne 9; figures 1-5 * ----- | 1-9 | DOMAINES TECHNIQUES RECHERCHES (IPC) H01P |
| Y | STEPHANE BILA ET AL: "Advanced design of microwave filters and multiplexers", MICROWAVE CONFERENCE PROCEEDINGS (APMC), 2011 ASIA-PACIFIC, IEEE, 5 décembre 2011 (2011-12-05), pages 63-65, XP032152571, ISBN: 978-1-4577-2034-5 * page 63, colonne de droite, ligne 1; figures 1,2 * * page 64, colonne de droite, ligne 1 - ligne 29; figures 3,6 * ----- -/-- | 1-9 | |

Le présent rapport a été établi pour toutes les revendications

| Lieu de la recherche | Date d'achèvement de la recherche | Examinateur |
|---|---|---|
| La Haye | 17 janvier 2014 | Pastor Jiménez, J |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

          ................................................................

& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 13 18 6807

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | A. GARCIA-LAMPEREZ ET AL: "Analytical synthesis of microwave multiport networks", 2004 IEEE MTT-S INTERNATIONAL MICROWAVE SYMPOSIUM DIGEST (IEEE CAT. NO.04CH37535), vol. 2, 1 janvier 2004 (2004-01-01), pages 455-458, XP055073024, DOI: 10.1109/MWSYM.2004.1336009 ISBN: 978-0-78-038331-9 * page 455, colonne de gauche, ligne 31 - ligne 42; figures 1,2,4 * ----- | 1-9 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| La Haye | 17 janvier 2014 | Pastor Jiménez, J |

CATEGORIE DES DOCUMENTS CITES

X : particulièrement pertinent à lui seul
Y : particulièrement pertinent en combinaison avec un
 autre document de la même catégorie
A : arrière-plan technologique
O : divulgation non-écrite
P : document intercalaire

T : théorie ou principe à la base de l'invention
E : document de brevet antérieur, mais publié à la
 date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 13 18 6807

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-01-2014

| Document brevet cité au rapport de recherche | | Date de publication | Membre(s) de la famille de brevet(s) | | Date de publication |
|---|---|---|---|---|---|
| EP 0987786 | A2 | 22-03-2000 | CA | 2282054 A1 | 18-03-2000 |
| | | | EP | 0987786 A2 | 22-03-2000 |
| | | | US | 6031434 A | 29-02-2000 |
| EP 0096461 | A2 | 21-12-1983 | AU | 549502 B2 | 30-01-1986 |
| | | | AU | 1313783 A | 08-12-1983 |
| | | | CA | 1194562 A1 | 01-10-1985 |
| | | | DE | 3382019 D1 | 10-01-1991 |
| | | | EP | 0096461 A2 | 21-12-1983 |
| | | | JP | H0312801 B2 | 21-02-1991 |
| | | | JP | S58220502 A | 22-12-1983 |
| | | | MX | 154088 A | 24-04-1987 |
| | | | US | 4504805 A | 12-03-1985 |

EPO FORM P0460

Pour tout renseignement concernant cette annexe : voir Journal Officiel de l'Office européen des brevets, No.12/82